# FASCICULE DE BREVET EUROPEEN

(11) **EP 3 072 148 B1**
(45) Date de publication et mention de la délivrance du brevet: **07.07.2021**
(21) Numéro de dépôt: 14814931.3
(22) Date de dépôt: 19.11.2014
(51) Int. Cl.: H01L 21/285, H01L 21/768

(54) **PROCÉDÉ DE PROTECTION D'UNE COUCHE DE SILICIURE**
VERFAHREN ZUM SCHUTZ EINER SILIZIDSCHICHT
METHOD OF PROTECTING A SILICIDE LAYER

(30) Priorité: 20.11.2013 FR 1361393
(43) Date de publication de la demande: 28.09.2016
(73) Titulaire: Commissariat à l'Énergie Atomique et aux Énergies Alternatives, 75015 Paris (FR)
(72) Inventeur: POSSEME, Nicolas, 38360 Sassenage (FR)
(74) Mandataire: Delorme, Nicolas
(86) Numéro de dépôt international: PCT/FR2014/052964
(87) Numéro de publication internationale: WO 2015/075379

(56) Documents cités:
- WO-A2-2012/122052
- JP-A- 2001 073 150
- JP-A- 2011 233 713
- US-A1- 2004 256 645
- US-A1- 2008 311 718
- US-A1- 2010 107 927
- US-A1- 2010 221 912
- US-A1- 2010 330 794
- US-A1- 2013 109 187

## Description

La présente invention concerne un procédé de protection d'une couche de siliciure destinée à former des contacts électriques pour des circuits intégrés.

La fabrication de contacts électriques pour circuits intégrés sur substrat de silicium implique la formation d'un matériau de siliciure sur le substrat afin de diminuer la résistance électrique de contact entre le matériau semi-conducteur et le métal du contact électrique. Ce matériau de siliciure est généralement formé à partir d'une couche de siliciure dont les zones qui serviront aux contacts sont exposées par une gravure localisée. Or, une fois mises au contact de l'air, ces zones se détériorent et forment un résidu à leur surface par réaction avec l'humidité de l'air et le reliquat du réactif de gravure. Ce résidu limite la qualité des contacts électriques formés ultérieurement, ce qui entraine une perte de rendement. Une augmentation de la défectivité des contacts est également observée, ce qui est d'autant plus critique que la taille des contacts diminue avec les nœuds technologiques. Les document US 2004/256645 A1 (TSUCHIAKI MASAKATSU [JP] ET AL) 23 décembre 2004 (2004-12-23) et US 2010/330794 A1 (KURISU HIROKAZU [JP] ET AL) 30 décembre 2010 (2010-12-30) décrivent un procédé de protection d'une couche de siliciure destinée à former des contacts électriques pour des circuits intégrés.

La gravure par voie humide du substrat et des zones de siliciure pour un nettoyage de la surface reste inefficace pour éviter la formation de ces résidus. Une autre solution consiste à appliquer un plasma d'oxygène. Mais une telle étape risque d'endommager le siliciure par oxydation ou modification de la composition chimique du siliciure. Une autre possibilité consiste en un nettoyage à base de N₂/H₂, implémenté in situ dans le réacteur de gravure. Toutefois, une fois les zones de siliciures mises au contact avec l'air, l'apparition des résidus est retardée mais ils finissent par se former avec le temps.

Un des buts de l'invention consiste à résoudre ce problème. A cet effet, la présente invention propose un procédé de protection d'une couche de siliciure destinée à former des contacts électriques pour des circuits intégrés, le procédé comprenant les étapes consistant à :
a) Fournir un empilement comprenant successivement
   un substrat,
   une couche de siliciure formée sur le substrat, et
   une couche de nitrure de silicium recouvrant au moins la couche de siliciure,
b) Graver des régions déterminées de la couche de nitrure de silicium de sorte à exposer au moins des zones de la couche de siliciure destinées à former les contacts électriques, par une gravure par plasma fluoré, tel qu'un plasma à base de CH₃F et
c) Déposer une couche de protection par un traitement par plasma à base d'au moins un gaz choisi parmi le CxHy, le CxOy, de sorte à déposer respectivement une couche de protection carbonée, le SixCly et le SixFy, de sorte à déposer une couche de protection siliciée, sur au moins les zones de la couche de siliciure exposées à l'étape b),
le procédé étant dépourvu d'étape d'exposition de l'empilement à l'humidité entre l'étape b) et l'étape c), notamment à l'humidité provenant de l'air ambiant.

Grâce à ce procédé, les reliquats des réactifs utilisés pour la gravure de la couche de nitrure de silicium sont retirés lors du dépôt de la couche de protection. Cette couche de protection ayant été formée sans contact intermédiaire entre les zones de la couche de siliciure exposées et l'humiditié entre l'étape b) et c), la corrosion de la couche de siliciure générant des résidus en présence des reliquats de gravure et d'humidité est empêchée. En effet, ce procédé permet d'éviter le contact ente le métal du siliciure, les reliquats des réactifs de gravure et l'humidité de l'air. La réaction parasite générant des résidus difficiles à retirer par gravure humide est alors empêchée.

Il est ensuite possible d'exposer l'empilement et les zones de siliciures à l'air ambiant sans risquer la formation desdits résidus. La suite du procédé de fabrication des composants peut alors être effectuée de façon classique.

Selon la présente invention, la gravure de l'étape b) est une gravure par plasma fluoré, tel qu'un plasma à base de CH₃F. Ce plasma fluoré est en effet très efficace pour graver sélectivement les régions déterminées de la couche de nitrure de silicium. Néanmoins, cette gravure laisse des traces de fluor en surface de l'empilement, ce qui favorise nettement la formation desdits résidus sur les zones de siliciure lorsque l'empilement est placé à l'air libre ou dans une atmosphère contenant de l'eau en absence de la couche de protection.

De préférence, les étapes b) et c) sont mises en œuvre dans la même enceinte d'un réacteur, de préférence un réacteur de type à couplage capacitif ou de type à couplage inductif. Il est ainsi possible de totalement éviter la formation de résidus en évitant la mise en contact avec l'humidité de l'air avant de former la couche de protection.

Selon une disposition, le procédé comprend après l'étape c), une étape d) consistant à appliquer à l'empilement un nettoyage par voie humide notamment par une solution de NH₄OH/H₂O₂. Ce nettoyage, effectué dans les conditions de nettoyage par voie humide de type SC1 (acronyme anglais de Standard Clean 1) permet de retirer les contaminants et autres résidus pouvant altérer la qualité de la métallisation des zones de siliciures.

Selon une autre disposition, le procédé comprend après l'étape d) une étape e) consistant à déposer une couche d'un métal, tel que le tungstène ou le cuivre, sur les zones de siliciure exposées à l'étape b) de sorte à former les contacts électriques. Ainsi, des contacts électriques performants sont formés sur les siliciures, tout en évitant la formation de résidus pouvant diminuer la surface des zones de contact.

De préférence, l'étape e) comprend en outre le dépôt d'une couche barrière métallique de Ta/TaN ou de Ti/TiN au préalable du dépôt de la couche de métal.

Selon la présente invention, l'étape c) de dépôt de la couche de protection est réalisée par un traitement par plasma.

Selon la présente invention, l'étape c) est réalisée par plasma à base de CxOy, tel que du CO ou du CO2, de sorte à former une couche de protection carbonée.

Selon une possibilité, le plasma à base de CxOy est formé en outre à partir d'un ou plusieurs gaz, choisi parmi l'azote et l'oxygène, fourni avec un débit compris entre 1 et 150 cm³/min. Ainsi, même avec une durée de dépôt de quelques secondes, il est possible de contrôler la vitesse et/ou l'épaisseur de la couche de protection déposée.

Selon la présente invention, l'étape c) est réalisée par plasma à base de CxHy, tel que du CH₄, de sorte à former une couche de protection carbonée.

De préférence, que le plasma soit à base de CxOy ou à base de CxHy, l'étape c) est réalisée de sorte que la couche de protection comprend une teneur en carbone supérieure à 30% et de préférence supérieure ou égale à 35%. Cette teneur en carbone assure en effet une protection optimale contre la formation de résidus de siliciure, notamment lorsque l'étape de gravure du nitrure de silicium est réalisée à base d'un plasma fluoré.

Selon la présente invention, l'étape c) est réalisée par plasma d'un gaz comprenant du silicium, tel que le SixCly ou le SixFy, et de préférence le SiCl₄ ou le SiF₄, de sorte à déposer une couche de protection siliciée.

Avantageusement, l'étape c) de dépôt de la couche de protection est réalisé par un plasma à base d'au moins un gaz choisi parmi CxHy, CxOy, SixCly et SixFy.

Typiquement, lors de l'utilisation d'un plasma à base de silicium ou de CxHy, l'étape c) est mise en œuvre avec un plasma formé en outre à partir d'un ou plusieurs gaz, choisi parmi l'azote et l'oxygène, fourni avec un débit compris entre 50 et 500 cm³/min. Ainsi, même avec une durée de dépôt de quelques secondes, il est possible de contrôler la vitesse et/ou l'épaisseur de la couche de protection déposée. Il est ainsi aisé de retirer cette couche de protection relativement mince le moment opportun venu.

Typiquement, la nature de la couche de siliciure est choisie parmi les natures de siliciures suivants: PtSi, NiPtSi, NiSi, NiSi₂, TiSi₂ (phase C54), TiSi₂ (phase C49), Co₂Si, CoSi, CoSi₂, WSi₂, MoSi₂, TaSi₂. Ces siliciures présentent en effet des résistances électriques réduites par rapport à celle d'un substrat semi conducteur, tel qu'un substrat en silicium. Il existe ainsi un grand choix de natures de siliciures disponible. Ce choix peut être effectué selon la résistance mécanique du contact souhaitée, la résistance à la température, ou la capacité à recevoir le métal finalisant le contact électrique.

De façon spécifique, l'étape b) comprend une étape b1) consistant à déterminer les régions de la couche de nitrure de silicium à graver, par une protection de portions de la couche de nitrure de silicium à préserver de la gravure avec une couche d'oxyde de silicium et une étape b2) consistant à graver les régions déterminées.

Dans une configuration particulière, l'étape b1) consistant à protéger des portions de la couche de nitrure de silicium à préserver de la gravure est réalisée par application d'un masque de gravure sur la couche d'oxyde de silicium, le masque comprenant des ouvertures traversantes à l'aplomb des régions déterminées de la couche de nitrure de silicium à graver.

Selon une possibilité, l'étape c) est mise en œuvre par plasma avec un débit gazeux de CxHy, SixCly ou SixFy compris entre 10 et 100 cm³/min ou un débit gazeux de CxOy compris entre 50 et 500 cm³/min. L'utilisation d'un plasma comprenant du Cl ou du F n'engendre pas de la formation de résidus à l'air comme lors de l'utilisation d'un plasma de gravure fluoré selon l'étape b) du procédé. La couche de protection déposée comprend majoritairement du silicium et le fluor ou le chlore du plasma utilisé est très volatile après remise à l'air de l'empilement.

Par ailleurs, l'étape c) est réalisée avec une pression comprise entre 10 et 200 mTorr.

La puissance de la source du réacteur est comprise entre 100 et 1000W lorsque le plasma est à base de CxHy ou de CxOy. La puissance de la source est comprise entre 100 et 500W dans le cas de plasma à base de SixCly ou de SixFy.

La puissance de polarisation (ou puissance bias) est comprise entre 0 et 200W.

La durée de l'étape c) est comprise entre 5 et 60 secondes pendant lesquelles l'empilement est placé à une température comprise entre 20 et 100°C.

D'autres aspects, buts et avantages de la présente invention apparaîtront mieux à la lecture de la description suivante d'un mode de réalisation de celle-ci, donnée à titre d'exemple non limitatif et faite en référence aux dessins annexés. Les figures ne respectent pas nécessairement l'échelle de tous les éléments représentés de sorte à améliorer leur lisibilité. Dans la suite de la description, par souci de simplification, des éléments identiques, similaires ou équivalents des différentes formes de réalisation portent les mêmes références numériques.
La figure 1 illustre une vue en coupe schématique d'un empilement comprenant un masque pour la détermination des régions de la couche de nitrure de silicium à graver selon un mode de réalisation de l'invention.
La figure 2 illustre une vue en coupe schématique d'un empilement à l'étape b1) du procédé selon un mode de réalisation de l'invention.
La figure 3 illustre une vue en coupe schématique d'un empilement à l'étape b) du procédé selon un mode de réalisation de l'invention.
La figure 4 illustre une vue en coupe schématique d'un empilement à l'étape c) du procédé selon un mode de réalisation de l'invention.
La figure 5 illustre une vue en coupe schématique d'un empilement à l'étape e) du procédé selon un mode de réalisation de l'invention.

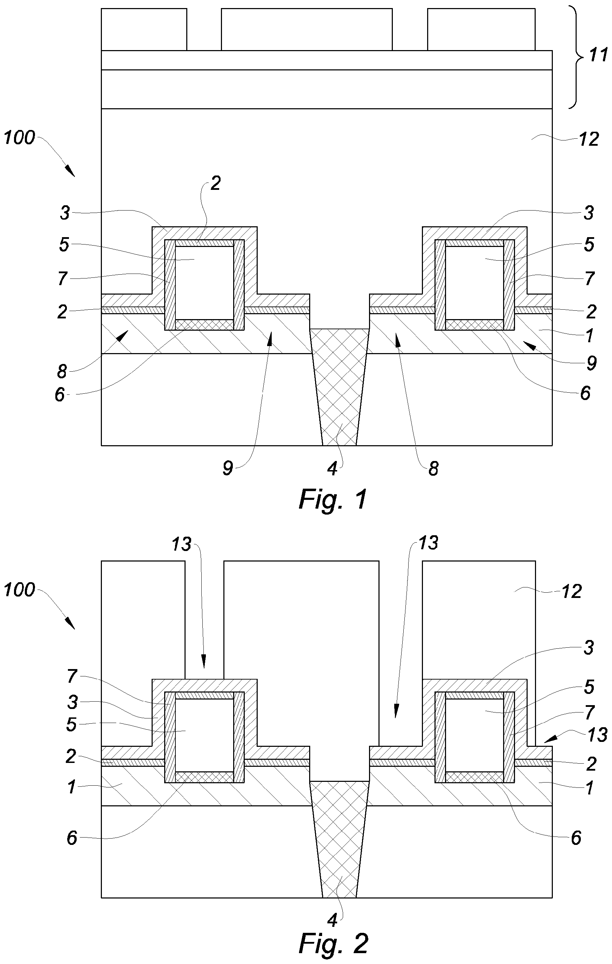

La figure 1 illustre un empilement 100 comprenant successivement un substrat 1, notamment en silicium, une couche de siliciure 2 et une couche de nitrure de silicium 3 selon l'étape a) du procédé.

A titre d'exemple, le substrat 1 illustré à la figure 1 est typiquement préparé pour une fabrication de transistors. Le substrat 1 comprend en effet une tranchée 4 prévue pour isoler les transistors, de l'oxyde de silicium SiO₂ sous le substrat 1 pour améliorer les performances des dispositifs notamment en limitant les courant de fuite, une grille 5 formée sur un matériau diélectrique 6, les flancs de la grille 5 étant recouverts d'un espaceur 7 en un matériau nitruré, une région pour la source 8 et une région pour le drain 9 surélevées par rapport à la grille.

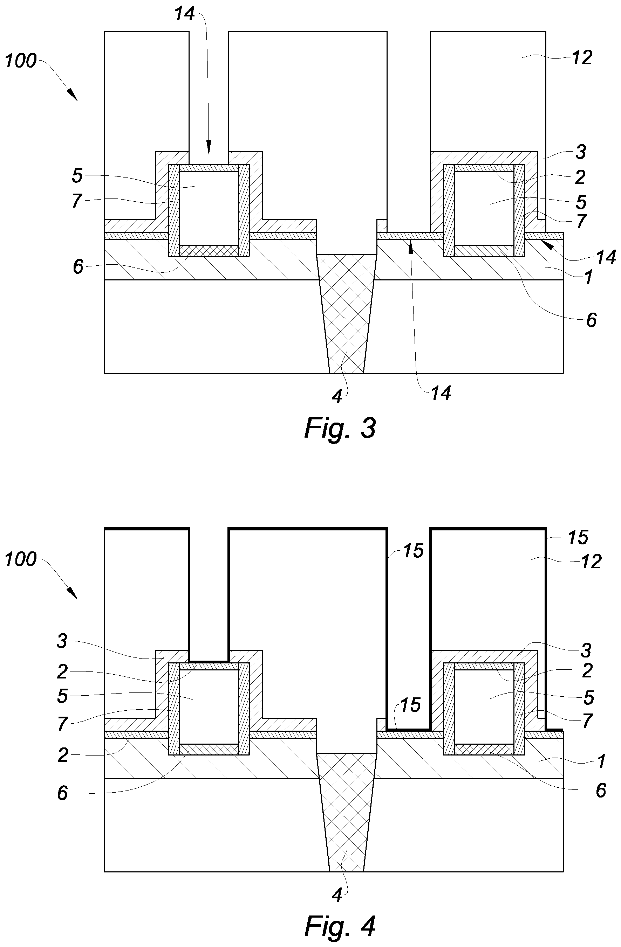

Selon l'étape b1) du procédé selon l'invention, l'empilement 100 comprend en outre un masque 11 disposé sur une couche d'oxyde de silicium 12 SiO₂ recouvrant la couche de nitrure de silicium 3. Ce masque 11 comprend des ouvertures permettant la gravure localisée (par exemple avec CF₄/C₄F₈) de la couche d'oxyde de silicium 12 (figure 2) et la détermination des régions 13 de la couche de nitrure de silicium 3 à graver. Le matériau à base de SiN de la couche 3 forme une couche d'arrêt à la gravure de la couche 12 de SiO₂, si bien que les ouvertures formées débouchent sur les régions 13 déterminées de la couche de nitrure de silicium 3 à graver. Le masque 11 est ensuite retiré par exemple par un plasma d'O₂ (figure 2) avant la gravure de ces régions 13 déterminées. La gravure est effectuée par plasma fluoré, tel qu'un plasma à base de CH₃F/Ar/O₂ choisi pour s'arrêter sélectivement à la couche de siliciure 2, de sorte à exposer les zones 14 de siliciure destinées à former des contacts électriques (étape b2) -figure 3). Une couche de protection 15 selon l'étape c) du procédé est ensuite déposée sur les zones 14 de siliciure exposées dans la même enceinte du réacteur ayant servie pour la gravure (figure 4). Le réacteur utilisé peut être un réacteur du type à couplage inductif ICP ou de type à couplage capacitif CCP. Ce dépôt réalisé in situ évite le contact des zones 14 de siliciure avec l'air et la formation de résidus notamment en présence de reliquats de réactif de gravure.

Selon une possibilité, de la présente invention, la couche de protection 15 est déposée par plasma à base de CxHy, et notamment de CH₄, de sorte à former une couche de protection 15 carbonée, notamment dans des conditions permettant d'atteindre une teneur en carbone supérieure à 30% et de préférence supérieure à 35%. A cet effet, les paramètres ci-dessous sont appliqués sachant que la teneur en carbone peut être contrôlée par l'analyse des surfaces par XPS (acronyme de X-ray Photoelectron Spectroscopy) :
- plasma à base de CxHy avec un débit compris entre 10 cm³/min et 100cm³/min comprenant en outre de l'azote ou de l'oxygène avec un débit compris entre 50-500cm³/min, sur une durée comprise entre 10 et 60 secondes, appliqué sur l'empilement 100 maintenu à une température comprise entre 20°C-100°C
- pression 10-200mTorr
- Puissance de la source 100-1000W
- Puissance de polarisation (ou puissance Bias- contrôle l'énergie des ions) comprise entre 0-200W.

Au-delà de cette puissance de polarisation, les éléments dérivés du plasma de carbone risquent d'être implantés dans la couche de siliciure 2 et de l'endommager.

Pour une couche de protection 15 carbonée de 2 nanomètres d'épaisseur, les conditions de dépôt consistent en l'exposition par exemple de l'empilement 100 pendant 10 secondes à un plasma de CH₄ et d'azote avec un débit respectivement de 20 cm³/min et de 80 cm³/min. La pression est de 50mTorr, la température de l'empilement 100 est de 60°C, la puissance de la source de 600W et la puissance de polarisation est de 100W.

Selon une autre possibilité, de la présente invention, la couche de protection 15 est déposée par plasma à base de CxOy, et notamment du CO ou du CO2, qui permettent d'atteindre une teneur en carbone supérieure à 30% et de préférence supérieure à 35% avec un mécanisme de dépôt identique à celui obtenu par plasma à base de CxHy. Par exemple, le plasma à base de CO peut être réalisé avec un débit compris entre 50 cm³/min et 500 cm³/min comprenant en outre de l'azote avec un débit compris entre 0-150 cm³/min, sur une durée comprise entre 10 et 60 secondes.

Selon une variante de réalisation, la couche de protection 15 est en matériau silicié. Dans ce cas, elle est déposée par plasma à base de SixCly ou SixFy, notamment de SiCl₄ ou respectivement de SiF₄, avec un débit compris entre 10 et 100 cm³/min. Un gaz tel que l'azote ou l'oxygène peut être ajouté au gaz silicié, avec un débit compris entre 50 et 500 cm³/min, afin d'augmenter la vitesse de dépôt. La puissance de la source est comprise entre 100 et 500W, la puissance de polarisation est de 0 à 200W, la durée du dépôt est comprise entre 5 et 60 secondes et la température de l'empilement 100 est maintenue entre 20 et 100°C.

Pour déposer une couche de protection 15 siliciée d'une épaisseur de 1-2 nm, un plasma de SiCl₄ est par exemple appliqué pendant 5 secondes avec un débit de 95 cm³/min accompagné d'azote avec un débit de 475 cm³/min. La puissance de la source utilisée est d'environ 100W, la puissance de polarisation est de zéro, et la pression est d'environ 10 mTorr.

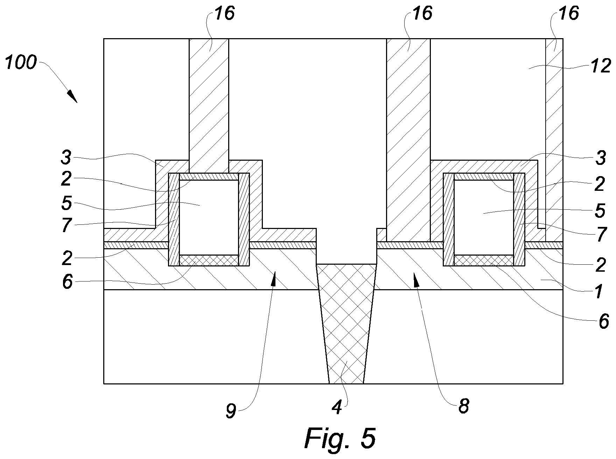

Comme illustré à la figure 5, une étape de métallisation est ensuite effectuée afin de former les contacts électriques après nettoyage de l'empilement 100 recouvert de la couche de protection 15. Selon une possibilité, le nettoyage selon l'étape d) du procédé est réalisé par exposition de l'empilement 100 à une chimie de type SC1 comprenant une solution de NH₄OH/H₂O₂. Ce nettoyage permet de retirer les reliquats de réactifs, des contaminants éventuels et la couche de protection 15 lorsque celle-ci est en matériau silicié.

La métallisation selon l'étape e) du procédé est enfin réalisée par dépôt d'une couche de métal 16, tel que du tungstène et une étape préalable de pulvérisation (sputtering) sur les zones 14 de siliciure exposées. Cette étape de pulvérisation permet en effet d'éliminer la couche de protection 15 lorsqu'elle est en matériau carboné (excepté sur les flancs - non illustré sur la figure 5) mais également une éventuelle oxydation des zones 14 de siliciure avant dépôt du tungstène.

Dans le cas d'une couche de métal 16 en cuivre, le dépôt est réalisé ECD (ElectroChemical Déposition).

La couche de siliciure 2 peut être constituée de nombreux alliages de métaux et de silicium et peut notamment être choisi parmi le PtSi, NiPtSi, NiSi, NiSi₂, TiSi₂ (phase C54), TiSi₂ (phase C49), Co₂Si, CoSi, CoSi₂, WSi₂, MoSi₂, et le TaSi₂.

Ainsi, la présente invention apporte une amélioration déterminante à l'état de la technique antérieure en proposant un procédé de protection de zones 14 de siliciures pour la formation de contacts électriques efficaces, de façon rapide et précise. Il en résulte que les dispositifs formés à partir de ces zones de contact sont fiables et présentent une performance améliorée.

## Revendications

1. Procédé de protection d'une couche de siliciure (2) destinée à former des contacts électriques pour des circuits intégrés, le procédé comprenant les étapes consistant à :
a) Fournir un empilement (100) comprenant successivement
un substrat (1),
une couche de siliciure (2) formée sur le substrat (1), et
une couche de nitrure de silicium (3) recouvrant au moins la couche de siliciure (2),
b) Graver des régions (13) déterminées de la couche de nitrure de silicium (3) de sorte à exposer au moins des zones (14) de la couche de siliciure (2) destinées à former les contacts électriques, par une gravure par plasma fluoré, tel qu'un plasma à base de CH₃F et
c) Déposer une couche de protection (15) par un traitement par plasma à base d'au moins un gaz choisi parmi le CxHy, le CxOy, de sorte à déposer respectivement une couche de protection (15) carbonée, le SixCly et le SixFy, de sorte à déposer une couche de protection (15) siliciée, sur au moins les zones (14) de la couche de siliciure (2) exposées à l'étape b),
le procédé étant dépourvu d'étape d'exposition de l'empilement (100) à l'humidité entre l'étape b) et l'étape c), notamment à l'humidité provenant de l'air ambiant.

2. Procédé de protection selon la revendication 1, dans lequel les étapes b) et c) sont mises en œuvre dans la même enceinte d'un réacteur, de préférence un réacteur de type à couplage capacitif ou de type à couplage inductif.

3. Procédé de protection selon l'une des revendications 1 à 2, dans lequel le procédé comprend après l'étape c), une étape d) consistant à appliquer à l'empilement (100) un nettoyage par voie humide, notamment par une solution de NH₄OH/H₂O₂.

4. Procédé de protection selon la revendication 3, dans lequel le procédé comprend après l'étape d) une étape e) consistant à déposer une couche d'un métal (16), tel que le tungstène ou le cuivre, sur les zones (14) de la couche de siliciure exposées à l'étape b) de sorte à former les contacts électriques.

5. Procédé de protection selon l'une des revendications 1 à 4, dans lequel l'étape c) est réalisée par plasma à base de CxOy, tel que du CO ou du CO2, de sorte à former une couche de protection (15) carbonée.

6. Procédé de protection selon l'une des revendications 1 à 4, dans lequel l'étape c) est réalisée par plasma à base de CxHy, tel que du CH₄, de sorte à former une couche de protection (15) carbonée.

7. Procédé de protection selon l'une des revendications 5 à 6, dans lequel l'étape c) est réalisée de sorte que la couche de protection (15) comprend une teneur en carbone supérieure à 30% et de préférence supérieure ou égale à 35%.

8. Procédé de protection selon l'une des revendications 1 à 4, dans lequel l'étape c) est réalisée par plasma d'un gaz comprenant du silicium, tel que le SixCly ou le SixFy, et de préférence le SiCl₄ ou le SiF₄, de sorte à déposer une couche de protection (15) siliciée.

9. Procédé de protection selon l'une des revendications 6 à 8, dans lequel l'étape c) est mise en œuvre avec un plasma formé en outre à partir d'un ou plusieurs gaz choisi parmi l'azote et l'oxygène, fourni avec un débit compris entre 50 et 500 cm³/min.

10. Procédé de protection selon l'une des revendications 1 à 9, dans lequel la nature de la couche de siliciure (2) est choisie parmi les natures de siliciures suivants : PtSi, NiPtSi, NiSi, NiSi₂, TiSi₂ (phase C54), TiSi₂ (phase C49), Co₂Si, CoSi, CoSi₂, WSi₂, MoSi₂, TaSi₂.

11. Procédé de protection selon l'une des revendications 1 à 10, dans lequel l'étape b) comprend une étape b1) consistant à déterminer les régions (13) de la couche de nitrure de silicium (3) à graver par une protection de portions de la couche de nitrure de silicium (3) à préserver de la gravure avec une couche d'oxyde de silicium (12) et une étape b2) consistant à graver les régions (13) déterminées.

12. Procédé de protection selon la revendication 11, dans lequel l'étape b1) consistant à protéger des portions de la couche de nitrure de silicium (3) à préserver de la gravure est réalisée par application d'un masque (11) de gravure sur la couche d'oxyde de silicium (12), le masque (11) comprenant des ouvertures traversantes à l'aplomb des régions (13) déterminées de la couche de nitrure de silicium (3) à graver.

## Patentansprüche

1. Verfahren zum Schutz einer Silizidschicht (2), die dazu bestimmt ist, elektrische Kontakte für integrierte Schaltungen zu bilden, wobei das Verfahren folgende Schritte umfasst:
a) Bereitstellen eines Stapels (100), der aufeinanderfolgend
ein Substrat (1),
eine Silizidschicht (2), die auf dem Substrat (1) gebildet ist, und
eine Siliziumnitridschicht (3), die wenigstens die Silizidschicht (2) bedeckt, umfasst,
b) Ätzen von bestimmten Bereichen (13) der Siliziumnitridschicht (3), um wenigstens Zonen (14) der Silizidschicht (2) freizulegen, die dazu bestimmt sind, die elektrischen Kontakte zu bilden, durch Ätzen mittels Fluorplasma, wie eines Plasmas auf Basis von CH₃F und
c) Aufbringen einer Schutzschicht (15) durch eine Behandlung mittels Plasma auf Basis von wenigstens einem Gas, das gewählt wird aus CxHy, CxOy, um jeweils eine kohlenstoffhaltige Schutzschicht (15) aufzubringen, SixCly und SixFy, um eine siliziumhaltige Schutzschicht (15) aufzubringen, auf wenigstens jene Zonen (14) der Silizidschicht (2), die in dem Schritt b) freigelegt wurden,
wobei das Verfahren keinen Schritt der Feuchtigkeitsexposition des Stapels (100) zwischen dem Schritt b) und dem Schritt c) umfasst, insbesondere der Feuchtigkeit aus der Umgebungsluft.

2. Verfahren zum Schutz nach Anspruch 1, wobei die Schritte b) und c) in dem gleichen Reaktorgefäß umgesetzt werden, vorzugsweise ein Reaktor vom Typ mit kapazitiver Kopplung oder vom Typ mit induktiver Kopplung.

3. Verfahren zum Schutz nach einem der Ansprüche 1 bis 2, wobei das Verfahren nach dem Schritt c) einen Schritt d) umfasst, der darin besteht, auf den Stapel (100) eine Nassreinigung anzuwenden, insbesondere durch eine Lösung aus NH₄OH/H₂O₂.

4. Verfahren zum Schutz nach Anspruch 3, wobei das Verfahren nach dem Schritt d) einen Schritt e) umfasst, der darin besteht, eine Metallschicht (16), wie Tungsten oder Kupfer, auf jene Zonen (14) der Silizidschicht aufzubringen, die in dem Schritt b) freigelegt wurden, um die elektrischen Kontakte zu bilden.

5. Verfahren zum Schutz nach einem der Ansprüche 1 bis 4, wobei der Schritt c) mittels Plasma auf Basis von CxOy, wie CO oder CO2, ausgeführt wird, um eine kohlenstoffhaltige Schutzschicht (15) zu bilden.

6. Verfahren zum Schutz nach einem der Ansprüche 1 bis 4, wobei der Schritt c) mittels Plasma auf Basis von CxHy, wie CH₄, ausgeführt wird, um eine kohlenstoffhaltige Schutzschicht (15) zu bilden.

7. Verfahren zum Schutz nach einem der Ansprüche 5 bis 6, wobei der Schritt c) so ausgeführt wird, dass die Schutzschicht (15) einen Kohlenstoffgehalt umfasst, der größer als 30 % und vorzugsweise größer oder gleich 35 % ist.

8. Verfahren zum Schutz nach einem der Ansprüche 1 bis 4, wobei der Schritt c) mittels Plasma eines Gases ausgeführt wird, das Silizium umfasst, wie SixCly oder SixFy und vorzugsweise SiCl₄ oder SiF₄, um eine siliziumhaltige Schutzschicht (15) aufzubringen.

9. Verfahren zum Schutz nach einem der Ansprüche 6 bis 8, wobei der Schritt c) mit einem Plasma umgesetzt wird, das weiter ausgehend von einem oder mehreren Gasen gebildet wird, die gewählt werden aus Stickstoff und Sauerstoff, bereitgestellt mit einem Durchsatz, der zwischen 50 und 500 cm³/min beträgt.

10. Verfahren zum Schutz nach einem der Ansprüche 1 bis 9, wobei die Art der Silizidschicht (2) gewählt wird aus folgenden Silizidarten: PtSi, NiPtSi, NiSi, NiSi₂, TiSi₂ (Phase C54), TiSi₂ (Phase C49), Co₂Si, CoSi, CoSi₂, WSi₂, MoSi₂, TaSi₂.

11. Verfahren zum Schutz nach einem der Ansprüche 1 bis 10, wobei der Schritt b) einen Schritt b1) umfasst, der darin besteht, die Bereiche (13) der Siliziumnitridschicht (3) zu bestimmen, die zu ätzen sind, durch einen Schutz von Abschnitten der Siliziumnitridschicht (3), die vor der Ätzung mit einer Siliziumoxidschicht (12) zu bewahren sind, und einen Schritt b2), der darin besteht, die bestimmten Bereiche (13) zu ätzen.

12. Verfahren zum Schutz nach Anspruch 11, wobei der Schritt b1), der darin besteht, Abschnitte der Siliziumnitridschicht (3) zu schützen, die vor der Ätzung zu bewahren sind, ausgeführt wird durch Anwenden einer Ätzmaske (11) auf die Siliziumoxidschicht (12), wobei die Maske (11) Durchgangsöffnungen umfasst, die im Lot sind mit den bestimmten Bereichen (13) der zu ätzenden Siliziumnitridschicht (3).

## Claims

1. A protection method for protecting a silicide layer (2) intended to form electrical contacts for integrated circuits, the protection method comprising the steps consisting in :
a) Providing a stack (100) comprising successively:
a substrate (1),
a silicide layer (2) formed on the substrate (1), and
a silicon nitride layer (3) covering at least the silicide layer (2),
b) Etching determined regions (13) of the silicon nitride layer (3) so as to expose at least areas (14) of the silicide layer (2) intended to form the electrical contacts, by fluorinated plasma etching, such as a CH₃F-based plasma and
c) Depositing a protective layer (15) by a plasma treatment based on at least one gas selected among CxHy, CxOy so that to deposit a carbon-containing protective layer (15), SixCly and SixFy so that to deposit a silicide-containing protective layer (15) at least over the areas (14) of the silicide layer (2) exposed at step b),
the protection method being devoid of any step of exposition of the stack (100) to humidity between step b) and step c), in particular to ambient air humidity.

2. The protection method according to claim 1, wherein steps b) and c) are implemented in the same chamber of a reactor, preferably a capacitively-coupled or inductively-coupled reactor.

3. The protection method according to any of claims 1 to 2, wherein the protection method comprises, after step c), a step d) consisting in subjecting the stack (100) to a wet cleaning, in particular using a NH₄OH/H₂O₂ solution.

4. The protection method according to claim 3, wherein the protection method comprises, after step d), a step e) consisting in depositing a layer of a metal (16), such as tungsten or copper, over the areas (14) of the silicide layer exposed at step b) so as to form the electrical contacts.

5. The protection method according to any of claims 1 to 4, wherein step c) is carried out by CxOy-based plasma, such as CO-based or CO2-based plasma, so as to form a carbon-containing protective layer (15).

6. The protection method according to any of claims 1 to 4, wherein step c) is carried out by CxHy-based plasma, such as CH4-based plasma, so as to form a carbon-containing protective layer (15).

7. The protection method according to any of claims 5 to 6, wherein step c) is carried out so that the protective layer (15) comprises a carbon content higher than 30% and preferably higher than or equal to 35%.

8. The protection method according to any of claims 1 to 4, wherein step c) is carried out using plasma of a gas comprising silicon, such as SixCly or SixFy, and preferably SiCl₄ or SiF₄, so as to deposit a silicon-containing protective layer (15).

9. The protection method according to any of claims 6 to 8, wherein step c) is implemented using a plasma further formed from one or several gas(es) selected among nitrogen and oxygen, provided at a flow rate comprised between 50 and 500 cm³/min.

10. The protection method according to any of claims 1 to 9, wherein the nature of the silicide layer (2) is selected among the following natures of silicides : PtSi, NiPtSi, NiSi, NiSi₂, TiSi₂ (C54 phase), TiSi₂ (C49 phase), Co₂Si, CoSi, CoSi₂, WSi₂, MoSi₂, TaSi₂.

11. The protection method according to any of claims 1 to 10, wherein step b) comprises a step b1) consisting in determining the regions (13) of the silicon nitride layer (3) to be etched by a protection of portions of the silicon nitride layer (3) to be preserved from etching with a silicon oxide layer (12), and a step b2) consisting in etching the determined regions (13).

12. The protection method according to claim 11, wherein step b1), consisting in protecting portions of the silicon nitride layer (3) to be preserved from etching, is carried out by application of an etching mask (11) over the silicon oxide layer (12), the mask (11) comprising through openings in line with the determined regions (13) of the silicon nitride layer (3) to be etched.
